Europäisches Patentamt

European Patent Office

Office européen des brevets

(19)

(11) Publication number : **0 508 721 A1**

# (12) EUROPEAN PATENT APPLICATION

(21) Application number : **92303066.2**

(22) Date of filing : **07.04.92**

(51) Int. Cl.$^5$ : **C23C 30/00, C23C 14/16, C23C 16/14, C25D 3/50**

(30) Priority : **08.04.91 GB 9107364**

(43) Date of publication of application :
**14.10.92 Bulletin 92/42**

(84) Designated Contracting States :
**PT**

(71) Applicant : **SKW METALS UK LIMITED**
**89/95 Ferry Lane**
**Rainham, Essex RM13 9DP (GB)**

(72) Inventor : **Crosby, Jeffrey Norman**
**28 Bader Park, Bowerhill**
**Melksham, Wiltshire (GB)**
Inventor : **Daniels, Richard Steven**
**11 Cowslip Grove, Edmonds Meadow**
**Calne, Wiltshire (GB)**

(74) Representative : **Senior, Janet et al**
**Abel & Imray Northumberland House 303-306**
**High Holborn**
**London WC1V 7LH (GB)**

(54) **Coated molybdenum parts and process for their production.**

(57)    The present invention provides an article comprising a molybdenum substrate and having a ruthenium coating. Preferably the ruthenium coating lies directly on the molybdenum substrate, having been applied in two coating steps. Alternatively, one or more other intermediate layers is present. The article may be prepared, for example, by cleaning and etching the molybdenum substrate, subjecting the cleaned and etched substrate, if desired, to an initial heat treatment in a reducing or suitable inert atmosphere or vacuum, applying an intermediate layer to the molybdenum substrate, subjecting the product so obtained to a heat treatment in a reducing or suitable inert atmosphere or vacuum, applying a ruthenium layer, and, if desired, subjecting the product to a final heat treatment in a reducing or suitable inert atmosphere or vacuum. Surprisingly, high integrity ruthenium layers can be achieved in a reproducible manner.

EP 0 508 721 A1

Jouve, 18, rue Saint-Denis, 75001 PARIS

The present invention relates to coated parts comprising coated molybdenum substrates and a process for their production.

Molybdenum is extensively used as a carrier in semiconductor devices since its coefficient of thermal expansion is closely similar to that of silicon. Thus, for example, molybdenum parts may be used as heat conductors in high-power semiconductor devices.

The molybdenum components may be, for example, of simple shapes, and are usually flat. Components may be, for example, in the range of from 0.25 to 5 mm thick; a disc or "washer" may be, for example, in the range of from 5 to 100 mm diameter, but smaller parts of square or rectangular shape, e.g. about 0.5 mm square, are also routinely manufactured. The dimensions are held to a very close tolerance. The components are used, for example, in integrated circuits, laser devices, drive units of locomotives, robotics and missiles, etc..

Since molybdenum is readily oxidised in air the molybdenum parts are preferably coated with a protective layer; the protective layer also confers further advantages such as improved solderability and a lowered electrical contact resistance. Molybdenum substrates are, however, intrinsically difficult to coat.

Previous coating layers used have included nickel, silver, gold, copper, chromium, rhodium and palladium.

We have now found, surprisingly, that ruthenium is a suitable coating material for an article comprising a molybdenum substrate.

The present invention provides molybdenum parts having a coating comprising ruthenium. The coating on the parts is, for example, at least 0.05 micron thick, usually at least 0.1 micron thick, and may be up to 5 microns, preferably up to 1.2 micron, especially 0.15 to 1.2 micron thick, e.g. at least 0.2 micron, especially at least 0.25 micron, e.g. at least 0.3 micron, and for example up to 0.8 micron, preferably up to 0.6 micron, especially up to 0.5 micron, for example up to 0.4 or up to 0.35 micron. Advantageously, a coherent layer of ruthenium is present as the top layer and if desired the coating consists entirely of ruthenium.

Although ruthenium plating processes are known, there has been no prior use of ruthenium to coat molybdenum. Ruthenium coating *per se* is known in the art to be very difficult to achieve and, for example, ruthenium has not received widespread electroplating use because of difficulties in plating moderately thick ruthenium layers that are not brittle or prone to crack due to internal stress. In addition to this is the difficulty in coating molybdenum substrates. Contrary to expectation, we have found that molybdenum can be coated with a high integrity ruthenium layer in a reproducible manner.

The coated article is highly resistant to oxidation and chemical attack, and the ruthenium has high hardness, low electrical resistance and good resistance to abrasive wear.

Surprisingly, even though molybdenum substrates are intrinsically difficult to coat, and ruthenium coatings themselves are difficult and therefore expensive to achieve, excellent ruthenium-coatings can be obtained on molybdenum substrates, in an easy and cost-effective manner. We have found that, surprisingly, comparatively thin coating layers are possible and give satisfactory protection of the molybdenum: dense and continuous layers are achieved. Surprisingly also, comparatively thick coating layers are possible and give satisfactory coatings with no flaking.

Accordingly, the present invention provides an article comprising a molybdenum substrate and having a ruthenium coating.

More particularly, the present invention provides an article comprising a molybdenum substrate and having a ruthenium coating of from 0.05 to 5 microns thickness, usually at least 0.1 micron, preferably up to 1.2 micron, especially 0.15 to 1.2 micron, thickness, preferably up to 0.8 micron, for example 0.2 to 0.6 micron, more especially 0.25 to 0.35 micron, thickness.

The ruthenium coating may lie directly on the molybdenum substrate, having been applied in a single coating process or, more preferably, in more than one coating step.

In a different embodiment, one or more other intermediate layers are present. Suitable other layers are selected from elements of the 1st, 6th and 8th groups of the Periodic Table. Thus, for example, an intermediate layer may be nickel, silver, gold, cobalt, copper, chromium, rhodium or palladium, preferably nickel, gold, cobalt or rhodium.

The present invention provides a process for the production of an article comprising a molybdenum substrate and having a ruthenium coating, which comprises cleaning and etching the molybdenum substrate, if desired applying an intermediate layer to the substrate, and applying a ruthenium layer to the molybdenum substrate or the intermediate layer, and if desired subjecting the ruthenium-coated substrate or, if applicable and if desired, the intermediate layer to a heat treatment in a substantially oxygen-free atmosphere.

The process may, if desired, include a high temperature treatment after application of a ruthenium or other intermediate layer, the heat treatment being carried out at a temperature and for a time and in an atmosphere sufficient to ensure satisfactory adhesion of the subsequent ruthenium layer. Advantageously a sintering treatment is carried out at a temperature of at least 500°C, preferably at least 750°C, and advantageously up to 1100°C, preferably up to 900°C, for example in the range of from 500 to 1100°C, preferably from 750 to 900°C, most preferably 800 to 820°C.

Thus, for example, when an intermediate layer of ruthenium or other material is present, the process may comprise cleaning and etching the molybdenum substrate, applying a strike (or intermediate) layer to the molybdenum substrate, subjecting the product so obtained to a high temperature in a reducing or suitable inert atmosphere or low pressure atmosphere, and applying a layer of ruthenium.

Etching may be carried out, for example, with a standard acid etchant.

The ruthenium layer on top of an intermediate layer may for example have a thickness of up to 1 micron, preferably up to 0.7 micron, for example up to 0.6 micron; a thickness of for example 0.15 micron up to 0.5 micron, especially 0.2 micron up to 0.35 micron, should especially be mentioned. The thickness of the ruthenium layer may, however, exceed 1 micron for example if the latter two stages of the above process may be repeated. For example, a ruthenium-coated molybdenum substrate having, for example, a thickness of up to 0.4 micron may be subjected to a high temperature in a reducing or suitable inert atmosphere or vacuum and a further ruthenium layer, for example of thickness up to 0.4 micron, then applied.

The process optionally includes an additional step wherein the cleaned and etched molybdenum substrate is subjected to a high temperature in a suitable atmosphere prior to applying the intermediate or top layer. As with the optional high temperature treatment mentioned above, the initial heat treatment, if carried out, may help ensure satisfactory adhesion of the final ruthenium layer. Advantageously this high temperature treatment is carried out at a temperature of at least 500°C, preferably at least 750°C, and advantageously up to 1100°C, preferably up to 900°C, for example in the range of from 500 to 1100°C, preferably 750 to 900°C, most preferably 800 to 820°C.

An intermediate layer generally has a thickness of up to 0.2 microns, for example in the range of from 0.001 to 0.2 microns, preferably 0.001 to 0.1 micron, especially up to 0.05 micron, more especially substantially 0.03 micron or, for example, 0.03 to 0.05 micron. In general the maximum thickness would be lower, for example up to 0.1 micron, if the prior heat treatment is omitted.

Advantageously the intermediate layer comprises ruthenium.

The process optionally also includes a final high temperature sintering treatment in a suitable atmosphere; such treatment may lead to improved metallurgical bonds. Advantageously, the final high temperature treatment is carried out at a temperature of at least 200°C, preferably at least 500°C, and advantageously up to 1100°C, preferably up to 900°C, for example in the range of from 200 to 1100°C, preferably 500 to 900°C, most preferably 750 to 850°C.

The atmosphere may be the same or different for each of the heat treatments. A reducing atmosphere, for example hydrogen or a nitrogen/hydrogen mixture, e.g. "forming gas", or an inert atmosphere, for example of argon, may be used; a reducing atmosphere is preferred. Suitable pressures are, for example, up to 10 psi (up to approx. 0.7 atm), but other pressures may also be used; a suitable throughput of gas is, for example, 8 litres/minute. Alternatively a vacuum may be applied, for example down to $10^{-6}$ torr.

An intermediate layer and/or the ruthenium top layer may be applied by known methods, for example by electroplating or vapour phase deposition methods, for example by evaporation or spattering. Advantageously the layer or layers are applied by electroplating.

Thus, for example, the ruthenium layer or layers may be applied from known ruthenium electroplating solutions, preferably those operating at low pH values, although those operating at alkaline pH values may also be used.

Ruthenium electroplating solutions are known; advantageously the anion $[Ru_2NCl_8(H_2O)_2]^{3-}$ or a derivative thereof may be used. The corresponding potassium salt is described in USP 4,082,624. Advantageously, an electroplating solution contains $[Ru_2NCl_8(H_2O)_2]^{3-}$ or other anion(s) at a concentration in the range of up to 20 g/l, for example from 5 to 20 g/l, for example substantially 5 g/l or 10 g/l (expressed as ruthenium metal).

The solutions are usually used at low pH, for example up to pH 3, more especially up to pH 2, and advantageously at least pH 0.1, preferably at least pH 1, for example at a pH in the range of from 0.1 to 3 (preferably 1 to 2, most preferably 1 to 1.5) or 1.6 to 4.

An electroplating solution for applying a strike layer may be used at a different pH from that of an electroplating solution for applying the top ruthenium layer. For example, a solution for applying a strike layer may be used at a lower pH than the solution for applying the top ruthenium layer. The higher pH of the latter solution causes the ruthenium layer to be applied more rapidly than the rate of application of a strike layer.

For electroplating of ruthenium layers the current density is preferably in the range of from 0.05 to 4.0 A/dm², more especially from 0.5 to 2 A/dm². Electroplating is advantageously carried out with agitation and advantageously at a temperature in the range of from 20 to 85°C, preferably substantially 70°C.

An intermediate layer and/or the ruthenium top layer may also be applied to the molybdenum substrate by any other suitable technique; for example, in one embodiment of the invention, an intermediate layer and/or the ruthenium top layer is applied by vapour phase deposition.

Suitable methods whereby deposition occurs in controlled, low pressure atmospheres are, for example, known in the art. Pressures involved may be, for example, within the range $10^{-4}$ - $10^{-7}$ torr, preferably $10^{-5}$ - $10^{-6}$ torr, for example substantially $10^{-6}$ torr, or more of a vacuum, and substrate temperatures up to 400°C, preferably up to 300°C, may be used. Decomposition of the volatile ruthenium or other element may be performed by laser, plasma, heat, ion or atom beam sources, whereby the ruthenium or other source is decomposed into the ion or atom state. Chemical vapour deposition should also be mentioned.

Preferably final cleaning and heat treatment are carried out in the same reaction chamber as that used for a subsequent vapour phase deposition onto the same substrate.

The following Example illustrates the invention:

Example

A molybdenum disc of 41mm diameter and 0.6mm thickness was cleaned free of grease and soil using a proprietary aqueous alkaline metal cleaning solution (Activax - W. Canning, Birmingham, U.K.) and etched to a fully bright state using a water-sulphuric acid-nitric acid mixture as etchant. A strike layer of ruthenium metal having a thickness of 0.01 micron was then applied to the molybdenum substrate by electroplating. The electroplating solution was Englehard RU-8 and contained ruthenium at a concentration of 5 g/l. The pH of the solution was 1.7. The electroplating step was carried out at a temperature of 70°C and a current density of 0.66 A/dm$^2$ and for a period of 30 seconds. The product so obtained was then subjected to a heat treatment at 800°C for 20 minutes in an atmosphere of pure hydrogen.

A further ruthenium layer was then applied by electroplating as in the application of the strike layer, but at a current density of 1.0 A/dm$^2$ for a period of 8.75 minutes to give a ruthenium layer thickness of 0.36 micron.

The product so obtained was then subjected to a final heat treatment at 800°C for 7 minutes in an atmosphere of pure hydrogen to give a final product comprising a molybdenum disc coated with a ruthenium layer, this ruthenium layer being smooth, bright, fully adherent and free of defects such as cracks and areas of exfoliation.

**Claims**

1. An article comprising a molybdenum substrate and having a ruthenium coating.

2. An article as claimed in claim 1, wherein the ruthenium is coated directly onto the molybdenum substrate.

3. An article as claimed in claim 1, wherein the ruthenium is coated onto an intermediate layer selected from nickel, silver, gold, cobalt, copper, chromium, rhodium and palladium, itself coated directly onto the molybdenum substrate.

4. An article as claimed in any one of claims 1 to 3, wherein the ruthenium has a thickness of 0.15 to 0.8 micron.

5. An article as claimed in claim 4, wherein the ruthenium has a thickness of 0.2 to 0.6 micron.

6. A process for the production of an article comprising a molybdenum substrate and having a ruthenium coating as claimed in any one of claims 1 to 5, which comprises cleaning and etching the molybdenum substrate, if desired applying an intermediate layer to the substrate, and applying a ruthenium layer to the molybdenum substrate or the intermediate layer, and if desired subjecting the ruthenium-coated substrate or, if applicable, the intermediate layer and/or the ruthenium-coated substrate to a heat treatment in a substantially oxygen-free atmosphere.

7. A process as claimed in claim 6, wherein an intermediate layer is applied and is subjected to a heat treatment in a reducing or suitable inert atmosphere or low pressure atmosphere.

8. A process as claimed in claim 6 or claim 7, which also includes subjecting the cleaned and etched molybdenum substrate to an initial heat treatment in a reducing or suitable inert atmosphere or low pressure atmosphere prior to application of any layer.

9. A process as claimed in any one of claims 6 to 8, which includes a final heat treatment in a reducing or suitable inert atmosphere or low pressure atmosphere.

10. A process for the production of an article comprising a molybdenum substrate coated with a ruthenium layer, which comprises cleaning and etching the molybdenum substrate, subjecting the cleaned and etched substrate, if desired, to an initial heat treatment in a reducing or suitable inert atmosphere, applying an intermediate layer to the molybdenum substrate, subjecting the product so obtained to a heat treatment in a reducing or suitable inert atmosphere, applying a ruthenium layer, and, if desired, subjecting the product to a final heat treatment in a reducing or suitable inert atmosphere.

11. A process as claimed in any one of claims 6 to 10, wherein a ruthenium intermediate layer is applied.

12. A process as claimed in any one of claims 6 to 11, wherein the intermediate layer has a thickness of up to 0.1 micron.

13. A process as claimed in claim 12, wherein the intermediate layer has a thickness of up to 0.05 micron.

14. A process as claimed in any one of claims 7 to 13, wherein the heat treatment after the application of the intermediate layer is carried out at a temperature in the range of from 500 to 1100°C.

15. A process as claimed in claim 14, wherein the heat treatment is carried out at a temperature in the range of from 750 to 900°C.

16. A process as claimed in claim 15, wherein the heat treatment is carried out at a temperature in the range of from 800 to 820°C.

17. A process as claimed in any one of claims 8 to 16, wherein the initial heat treatment is carried out at a temperature in the range of from 500 to 1100°C.

18. A process as claimed in claim 17, wherein the initial heat treatment is carried out at a temperature in the range of from 750 to 900°C.

19. A process as claimed in any one of claims 9 to 18, wherein the final heat treatment is carried out at a temperature in the range of from 200 to 1100°C.

20. A process as claimed in claim 19, wherein the final heat treatment is carried out at a temperature in the range of from 500 to 900°C.

21. A process as claimed in claim 20, wherein the final heat treatment is carried out at a temperature in the range of from 750 to 850°C.

22. A process as claimed in any one of claims 6 to 21, wherein an intermediate layer and/or the ruthenium top layer is applied by electroplating.

23. A process as claimed in claim 22, wherein an electroplating solution containing $[Ru_2NCl_8(H_2O)_2]^{3-}$ at a concentration in the range of from 5 to 20 g/l (expressed as ruthenium metal) is used in the, or at least one of the, ruthenium electroplating steps.

24. A process as claimed in any one of claims 6 to 21, wherein an intermediate layer and/or the ruthenium top layer is applied by vapour phase deposition.

**European Patent Office**

# EUROPEAN SEARCH REPORT

Application Number

EP 92 30 3066

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 050 343 (LICENTIA PATENT-VERWALTUNGSG.M.B.H.) * claims 1-3,15 * | 1-10, 14-22 | C23C30/00 C23C14/16 C23C16/14 C25D3/50 |
| X | PATENT ABSTRACTS OF JAPAN vol. 007, no. 147 28 June 1983 & JP-A-58 058 299 ( DAIDO TOKUSHUKO ) 6 April 1983 * abstract * | 1 | |
| X | wpi/derwent , abstract nr. 74-35746v c19 derwent publications,london,gb %jp-a-49015747 (tokyo shibaura elec) 17-04-74 *abstract* | 1 | |
| A | DE-A-2 704 405 (DEMETRON GESELLSCHAFT FUR ELEKTRONIK-WERKSTOFFE) * page 2, line 1 - line 10 * * page 4, line 3 - line 19; claim 1 * | 1,4,11 | |
| A | US-A-4 082 622 (BODO G. GEBAUER) * claims 1,2; example 1 * | 22,23 | TECHNICAL FIELDS SEARCHED (Int. Cl.5 ) |
| A | wpi/derwent abstract nr. 78-90198a c50 derwent publications,london,gb &jp-a-53127316 (nippon teleg&teleph) 07-11-78 *abstract* | 22,24 | C23C C25D |

-----

The present search report has been drawn up for all claims

| Place of search | Date of completion of the search | Examiner |
|---|---|---|
| THE HAGUE | 17 JULY 1992 | ELSEN D.B. |

EPO FORM 1503 03.82 (P0401)